# EUROPEAN PATENT APPLICATION

(11) **EP 4 801 226 A1**
(43) Date of publication of application: **02.09.2026**
(21) Application number: 25781452.5
(22) Date of filing: 14.03.2025
(51) Int. Cl.: H10F 71/00

(54) **BASKET CLEANING AND DRYING SYSTEM**

(30) Priority: 03.04.2024 CN 202410398910
(71) Applicant: Changzhou S. C Exact Equipment Co., Ltd., Changzhou, Jiangsu 213133 (CN)
(72) Inventor: ZUO, Guojun, hangzhou, Jiangsu 213133 (CN); WAN, Hongchao, hangzhou, Jiangsu 213133 (CN); YU, Xingmei, hangzhou, Jiangsu 213133 (CN)
(74) Representative: Gille Hrabal Partnerschaftsgesellschaft mbB Patentanwälte
(86) International application number: PCT/CN2025/082736
(87) International publication number: WO 2025/209155

(57) **Abstract**

The present invention relates to solar cell production and manufacturing, and particularly relates a basket cleaning and drying system. The cleaning and drying system includes: a basket lifting apparatus, a cleaning tank, and a drying apparatus. The basket lifting apparatus is arranged above the cleaning tank; the drying apparatus is arranged beside the basket lifting apparatus; and the basket lifting apparatus, the cleaning tank, and the drying apparatus are integrally arranged, thus improving the production efficiency.

## Description

### Technical Field

The present invention relates to the technical field of solar cell production and manufacturing, and specifically relates to a basket cleaning and drying system.

### Background

In batch tank cleaning devices and batch wet processing devices for solar silicon wafers, objects being cleaned sequentially pass through batch tanks containing different chemical solutions to undergo chemical reactions and be fully immersed, and the objects are ultimately completely dried. Existing cleaning and drying systems are low in cleaning efficiency and drying efficiency, have high demands for floor space, are low in compatibility, and do not meet the development trends of solar cells for high efficiency, low cost, and large-scale production. Moreover, the existing cleaning and drying systems are not suitable for the construction of "Super Factory".

Therefore, it is urgently needed to provide a washing and drying system for a basket to solve the problem of low production efficiency in existing washing and drying systems.

### Summary

The present invention provides a basket cleaning and drying system, aiming to solve the technical problems mentioned in the Background.

In order to solve above technical problems, the present invention provides the basket cleaning and drying system, and the system includes: a basket lifting apparatus, a cleaning tank, and a drying device;
the basket lifting apparatus is arranged above the cleaning tank to lift the basket in the cleaning tank;
the drying device is arranged beside the basket lifting apparatus; and
the basket lifting apparatus is configured to convey the lifted basket into the drying device for drying.

The present invention has the beneficial effects that the basket cleaning and drying system includes the basket lifting apparatus, the cleaning tank, and the drying apparatus; the basket lifting apparatus is arranged above the cleaning tank to lift the basket in the cleaning tank; the drying apparatus is arranged beside the basket lifting apparatus; and the basket lifting apparatus is configured to convey the lifted basket into the drying apparatus for drying. The basket lifting apparatus, the cleaning tank, and the drying apparatus are integrally arranged, thus realizing the assembly line operation for silicon wafer cleaning and drying, and improving the production efficiency.

Other features and advantages of the present invention will be described in the following specification, and may in part become apparent from the specification, or be learned through practice of the present invention. The objectives and other advantages of the present invention are achieved and obtained through the structures specifically indicated in the specification and the accompanying drawings.

In order to make the above-mentioned objectives, features, and advantages of the present invention more apparent and easier to understand, specific preferred embodiments are listed below, with reference to the accompanying drawings, for a detailed description.

### Brief Description of the Drawings

In order to more clearly illustrate the specific embodiments of the present invention or the technical solution in the existing technology, the following will briefly introduce the accompanying drawings needed in the description of the specific embodiments or the existing technology. Obviously, the accompanying drawings described below are some of the embodiments of the present invention. For those of ordinary skill in the art, without the need for creative labor, other drawings can also be obtained based on these accompanying drawings.
FIG. 1 is a schematic diagram of mounting positions of a basket lifting apparatus and a cleaning tank according to some embodiments;
FIG. 2 is a planar schematic diagram of a basket lifting apparatus according to some embodiments;
FIG. 3 is a planar schematic diagram of a cross arm according to some embodiments;
FIG. 4 is a top view of a cross arm according to some embodiments;
FIG. 5 is a three-dimensional schematic structural diagram of a mobile column according to some embodiments;
FIG. 6 is a planar schematic diagram of a movable hanging plate according to some embodiments;
FIG. 7 is a planar schematic diagram of a cleaning tank according to some embodiments;
FIG. 8 is a schematic diagram of an internal structure of a cleaning tank according to some embodiments;
FIG. 9 is a planar schematic diagram of a drying apparatus in an upright state according to some embodiments;
FIG. 10 is a three-dimensional schematic structural diagram of a transfer platform according to some embodiments;
FIG. 11 is a three-dimensional schematic structural diagram of a transfer assembly according to some embodiments;
FIG. 12 is a planar schematic diagram of a drying apparatus in a stacked state according to some embodiments;
FIG. 13 is a three-dimensional schematic structural diagram of a transfer platform according to some embodiments; and
FIG. 14 is an enlarged schematic diagram of A in FIG. 13.

In the figures:
1, basket lifting apparatus; 11, cross beam; 11, side plate; 112, cover plate; 113, bottom plate; 12, mobile column; 120, basket driving cylinder; 121, column body; 13, hanging set; 130, accommodating position; 131, movable hanging plate; 130, hanging plate body; 1311, inclined pulling cylinder; 1312, hook; 1313, detection rod; 132, fixed hanging plate; 14, connecting rod; 15, manipulator slider; 16, connecting block;
2, cleaning tank; 21, main cleaning tank; 210, overflow port; 22, auxiliary cleaning tank; 23, overflow mesh; 24, flow equalizing screen; 25, bubbling pipe;
31, transfer apparatus; 32, drying device; 321, drying box; 322, cylinder door; 33, transfer platform; 331, bearing plate; 332, basket limiting plate; 333, accommodating groove; 34, transfer cylinder; 335, transposition assembly; 3351, first reversing cylinder; 3352, first picking plate; 3353, limiting step; 3354, second picking plate; 3355, second reversing cylinder; 34, loading and unloading apparatus; 341, tray driving cylinder; 342, tray bearing platform; 343, tray circulation mechanism;
35, dryer; 351, unloading door; 36, transfer platform; 361, basket holder; 361, basket support frame; 363, positioning groove; 364, horizontal cylinder; 365, vertical cylinder; and 37, blowing apparatus; and
4, basket.

### Detailed Description

In order to make the objectives, technical solutions, and advantages of the embodiments of the present invention clearer, the technical solutions of the present invention will be described clearly and completely below in conjunction with the accompanying drawings. Obviously, the described embodiments are part of the embodiments of the present invention, rather than all embodiments. Based on the embodiments in the present invention, all other embodiments obtained by those of ordinary skill in the art without making inventive efforts also fall within the protection scope of the present invention.

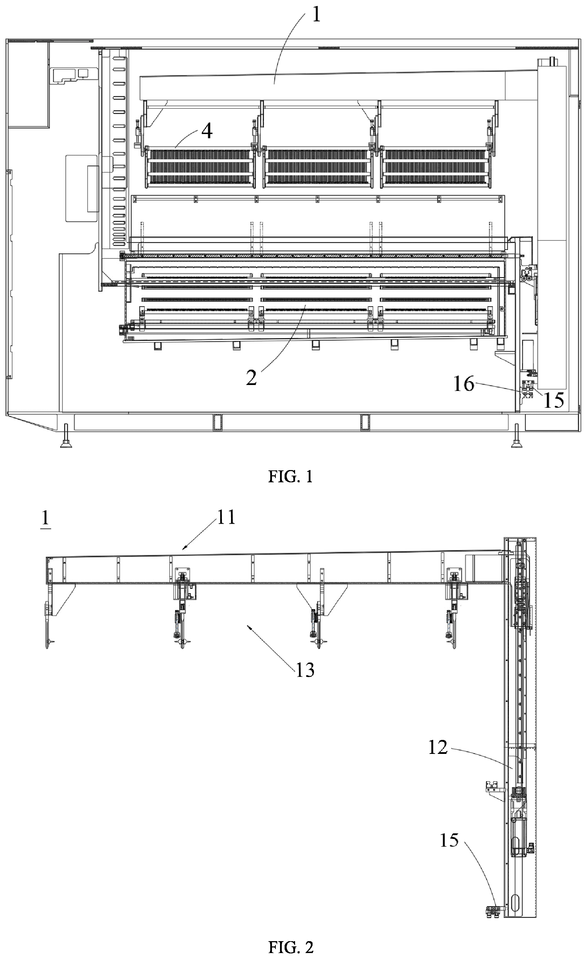

As shown in FIG. 1, FIG. 9, and FIG. 12, a basket cleaning and drying system provided by at least one embodiment includes: a basket lifting apparatus 1, a cleaning tank 2, and a drying apparatus; the basket lifting apparatus 1 is arranged above the cleaning tank 2 to lift a basket 4 in the cleaning tank 2; the drying apparatus is arranged beside the basket lifting apparatus 1; and the basket lifting apparatus 1 is configured to convey the lifted basket 4 into the drying apparatus for drying.

In some embodiments, the basket lifting apparatus 1 is configured to lift the basket 4 in the cleaning tank 2 and transfer the basket 4 into the drying apparatus for drying, thus realizing the transfer effect; and the basket lifting apparatus 1, the cleaning tank 2, and the drying apparatus are integrally arranged, thus realizing the assembly line operation for silicon wafer cleaning and drying, and improving the production efficiency.

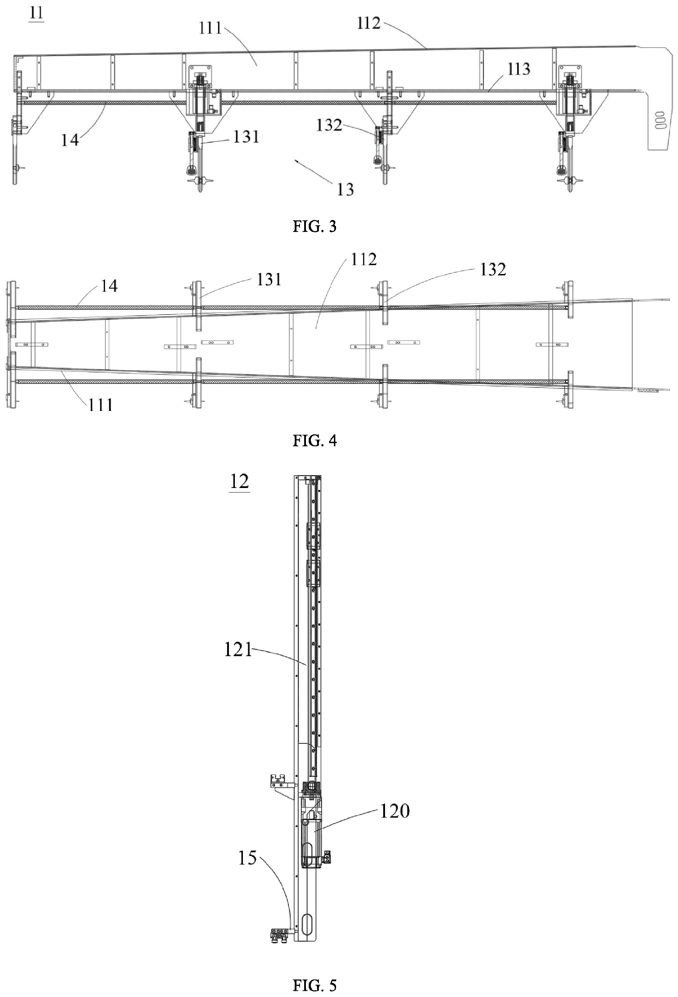

Specifically, as shown in FIG. 2 to FIG. 6, in some embodiments, the basket lifting apparatus 1 includes: a cross arm 11 on which at least three hanging sets 13 are arranged, each hanging set 13 containing at least two accommodating positions 130; each hanging set 13 consists of a fixed hanging plate 132 and a movable hanging plate 131; adjacent hanging sets 13 share one hanging plate; and a mobile column 12 is vertically arranged on one side of the cross arm 11 to bear and drive the cross arm 11 to move upwards.

In some embodiments, the at least three hanging sets 13 are arranged on the cross arm 11, each hanging set 13 is configured to contain at least two accommodating positions 130, at least one basket 4 can be placed in each accommodating position 130, and by means of repeatedly using the hanging plates, the baskets 4 can be hung as many as possible by the cross beam 11 under a limited length, thus the number of the hung baskets 4 is increased; moreover, each hanging set further includes at least one connecting rod 14; and two ends of each connecting rod 14 are correspondingly connected to the fixed hanging plates 132 and the movable hanging plates 131, thereby enhancing the strength of the cross arm 11.

In some embodiments, the cross arm 11 includes: a cover plate 112, a bottom plate 113, and at least two side plates 111; the two side plates 111 are arranged on the bottom plate 113, and top surface extension lines and bottom surface extension lines of the side plates 111 intersect each other at an end away from the mobile column 12. The cover plate 112 in a top view has a trapezoidal outline, with an end away from the mobile column 12 serving as an upper base. The bottom plate 113 in the top view has a trapezoidal outline, with the end close to the mobile column 12 serving as a lower base. The two side plates 111 are symmetrically arranged on the bottom plate 113 and are parallel to two side edges of the cover plate 112.

In some embodiments, the side plates 111 of the cross arm 11 are configured to be in a right-angled trapezoid, and therefore the strength of the cross arm 11 can be improved; and moreover, the cover plate 112, like the bottom plate 113, is configured as a trapezoid being narrow in the front and wide in the back, namely, the end close to the mobile column 12 is wide, and thus, the lifting strength of the cross arm 11 is enhanced.

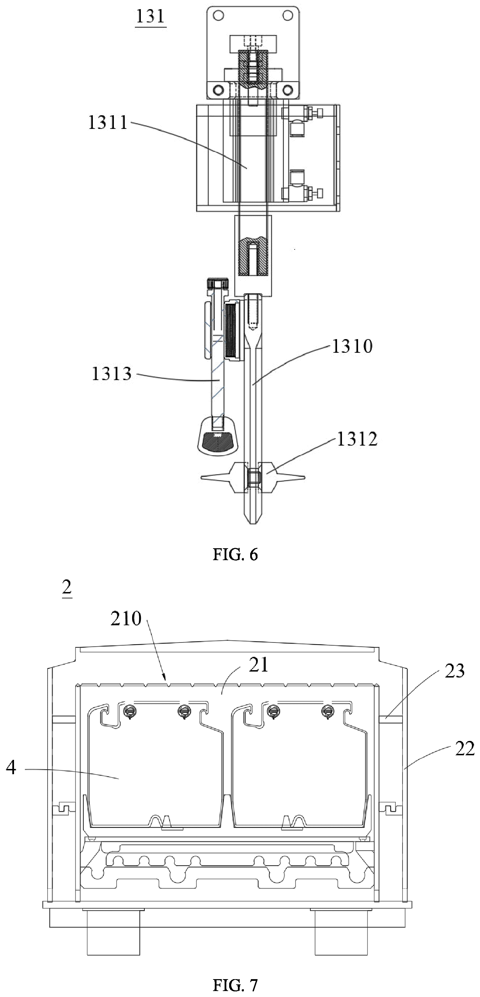

Specifically, as shown in FIG. 6 and FIG. 7, in some embodiments, the cross arm 11 is driven by the arranged mobile column 12 to move to lift the basket 4; the hanging set 13 is formed by at least two hanging plates arranged on the cross arm 11, one hanging plate is configured to be the movable hanging plate 131 while the other hanging plate is configured to be the fixed hanging plate 132, and one side of the basket 4 can be lifted up by the movable hanging plate 131 to enter an inclined state, thereby improving the effect of pouring medical solutions from the basket 4.

As a preferred embodiment, the mobile column 12 includes a column body 121 and a basket driving cylinder 120 arranged on the column body 121, and a telescopic end of the basket driving cylinder 120 is connected to the cross arm 11 to drive the cross arm 11 to move.

As an optional embodiment, the movement mode of the cross arm 11 can be replaced with a screw transmission or rack and pinion transmission mode.

In some embodiments, there are 4 hanging plates, and starting from the mobile column 12, the hanging plates are arranged in a sequence of the movable hanging plate 131, the fixed hanging plate 132, the movable hanging plate 131, and the fixed hanging plate 132, namely, the movable hanging plates 131 and the fixed hanging plates 132 are crosswise arranged. Thus, the basket 4 can be lifted up by the movable hanging plate 131, and then the mechanical solutions residual in the basket 4 can be poured out.

As a preferred embodiment, three hanging sets 13 are arranged on the cross arm 11, each hanging set 13 contains two accommodating positions 130; two rows of hanging plates are arranged on the cross arm 11, 4 hanging plates in each row; and therefore, the cross arm 11 can be fully loaded with 6 baskets 4.

In some embodiments, the fixed hanging plate 132 includes a hanging plate body 1310 which is fixedly connected to the cross arm 11; the movable hanging plate 131 includes a hanging plate body 1310 and an inclined pulling cylinder 1311, and a fixed end of the inclined pulling cylinder 1311 is arranged on the cross arm 11; and a telescopic end of the inclined pulling cylinder 1311 is connected to the hanging plate body 1310, and thus the hanging plate body 1310 can be driven by the inclined pulling cylinder 1311 to move upwards.

In some embodiments, detection mechanisms are arranged on the hanging plates and include detection rods 1313 and sensors; hanging gaps allowing the baskets 4 to be hung in are reserved between the bottoms of the detection rods 1313 and hooks 1312 at the bottoms of the hanging plates; after the baskets 4 are clamped into the hanging gaps, edges of the baskets 4 will jack and push the detection rods 1313 to move upwards, then the sensors will be triggered, thus whether the baskets 4 are hung or not can be detected; and the sensors include, but are not limited to, a displacement sensor.

As an optional embodiment, if it is needed to lift the basket 4 from the cleaning tank 2, a driving cylinder 120 is started by a control module and drives the cross arm 11 to descend along the column body 121 into the cleaning tank 2, thus the basket 4 can be hung by the hook 1312 at the bottom of each hanging plate; then the sensor on the hanging plate will detect whether the basket 4 is hung on the hook 1312 and uploads the resulted information to the control module; the control module controls the driving cylinder 120 to slowly lift up the basket 4 according to preset stroke parameters; and after reaching a certain height, the inclined pulling cylinder 1311 raises one side of the basket 4 so that there is a certain angle between the bottom of the basket 4 and the horizontal plane, thereby preventing the medical solution from being left over.

In some embodiments, the basket lifting apparatus 1 is further provided with a horizontal moving module, and the mobile column 12 is erected on the horizontal moving module, such that a movable column and the cross arm 11 can be driven to horizontally move; the horizontal moving module includes: a manipulator slider 15 and a connecting block 16; and the manipulator slider 15 is connected to the mobile column 12, and the manipulator slider 15 is erected on the connecting block 16. Therefore, the horizontal moving module can drive the mobile column 12 to slide, but the driving mode of the horizontal moving module includes, but is not limited to, a mode that a driving motor is adopted to push the manipulator slider 15 to move along the connecting block 16.

The connecting block 16 is arranged on a side wall of the cleaning tank 2, and thus a cleaning device can slide along the side wall of the cleaning tank 2.

As shown in FIG. 7, in some embodiments, the cleaning tank 2 includes a rectangular main cleaning tank 21 with an accommodating chamber, the main cleaning tank 21 being provided with at least two bearing modules in a width direction, each bearing module including at least three rectangular accommodating positions that are sequentially arranged in a length direction of the main cleaning tank 21, and the length direction of the accommodating positions being parallel to the length direction of the main cleaning tank; and an auxiliary cleaning tank 22 which is arranged around the main cleaning tank 21.

In some embodiments, the main cleaning tank 21 is configured to accommodate a medical solution for cleaning, and the auxiliary cleaning tank 22 arranged around the main cleaning tank 21 is configured to accommodate the medical solution overflowing from the main cleaning tank 21; the main cleaning tank 21 communicates with the auxiliary cleaning tank 22 through a medical solution pipeline, thus the medical solution overflowing from the main cleaning tank 21 can enter the auxiliary cleaning tank 22, then the medical solution in the auxiliary cleaning tank 22 circulates into the main cleaning tank 21 through the medical solution pipeline, thereby achieving the circulation and mixing of the medical solution in the cleaning tank 2.

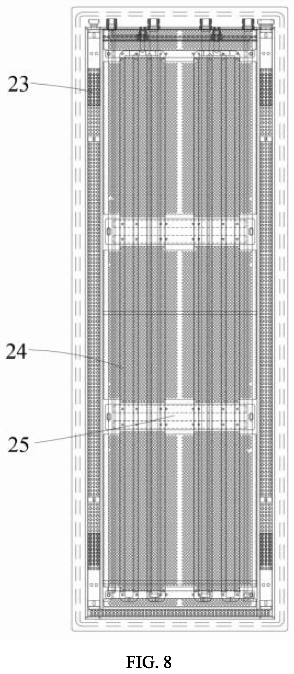

Specifically, as shown in FIG. 8, in some embodiments, an overflow screen 23 is arranged between the main cleaning tank 21 and the auxiliary cleaning tank 22. Specifically, the overflow screen 23 is arranged on an outer side wall of an upper end of the main cleaning tank 21 in modes including but not limited to a clamped mode, and it does not extend beyond the top of the main cleaning tank 21, and thus the medical solution overflowing from the main cleaning tank 21 enters the auxiliary cleaning tank 22 through the overflow screen 23; and by means of the overflow screen 23, the uniformity of the medical solution entering the auxiliary cleaning tank 22 can be improved.

In some embodiments, the well height of the main cleaning tank 21 is less than that of the auxiliary cleaning tank 22, and an overflow port 210 is formed in the upper end of the wall of the main cleaning tank 21 to make the medical solution in the tank overflow.

In some embodiments, a flow equalizing screen 24 is arranged at the bottom of the main cleaning tank 21, the medical solution in the auxiliary cleaning tank 22 flows through the medical solution pipeline (not shown in the figure) and then enters the main cleaning tank 21 through a medical solution inlet hole in the bottom of the main cleaning tank 21, the medical solution is equalized and mixed through the flow equalizing holes that are evenly distributed in the flow equalizing screen 24 and then flows into the main cleaning tank 21, and therefore the uniformity of the medical solution is improved, and the cleaning effect is improved.

In some embodiments, a bubbling pipe 25 is arranged in the main cleaning tank 21 and is located above the flow equalizing screen 24, a plurality of air holes are formed in the wall of the bubbling pipe 25; the bubbling pipe 25 supplies air into the main cleaning tank 21 through an external air source, and the air is blown into the main cleaning tank 21 through the air holes, thereby further improving the uniformity of the medical solution in the main cleaning tank 21; and moreover, because of the air, the medical solution can keep flowing circulation all the time, the silicon wafers can be completely cleaned, and the cleaning effect is improved.

As a preferred embodiment, the main cleaning tank 21 is further connected to a replenishing pipe (not shown in the figure), and thus the medical solution can be continuously replenished into the main cleaning tank 21, keeping the medical solution in the main cleaning tank 21 in an overflowing state at all times.

As an optional embodiment, the replenishing pipe is arranged at the bottom of the main cleaning tank 21, the medical solution flows through the replenishing pipe and the flow equalizing screen 24 and then enters the main tank; as the medical solution in the main cleaning tank 21 continues to be replenished, the medical solution in the main cleaning tank 21 will overflow from the top of the main cleaning tank 21, and the overflowed medical solution is equalized by the overflow screen 23 and then flows into the auxiliary cleaning tank 22; and because the auxiliary cleaning tank 22 communicates the main cleaning tank 21 through the medical solution pipeline, the medical solution in the auxiliary cleaning tank 22 can be returned into the main cleaning tank 21, thus realizing the circulation of the medical solution.

In some embodiments, the cleaning tank 2 is rectangular; and based on the length of the long side of the cleaning tank 2, in order to further improve the ventilation effect in the cleaning tank 2, a blowing pipe (not shown in the figure) and a suction pipe (not shown in the figure) are arranged above the cleaning tank 2, thereby ensuring the ventilation effect; and moreover, the blowing pipe and the suction pipe are generally arranged on the cleaning tank 2 in which harmful gas will be produced. Additionally, during placing the basket 4 into the cleaning tank 2 by the basket lifting apparatus 1 above the cleaning tank 2, the medical solution in the tank remains in a bubbling and overflowing state, which can improve the cleaning effect; and after being cleaned, the basket is conveyed to the drying apparatus by the basket lifting apparatus 1. A cover (not shown in the figure) is arranged at an opening in the top of the main cleaning tank 21, which can prevent the solution in the main cleaning tank 21 from volatilizing.

In some embodiments, the cleaning tank 2 is positioned in combination with the basket lifting apparatus 1 and the drying apparatus, and thus during lifting the basket 4 from the cleaning tank into the drying apparatus by the basket lifting apparatus 1, the silicon wafer cleaning and drying can be integrated.

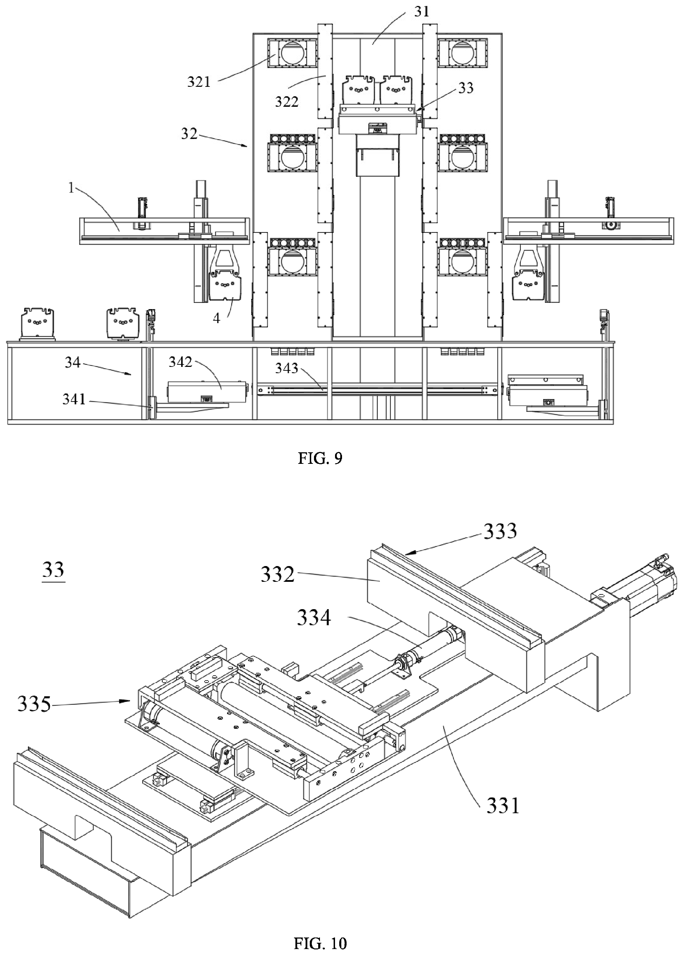

As shown in FIG. 9, as an optional embodiment, the drying apparatus is upright and includes: a transfer apparatus 31 including a transfer platform 33; and a drying device 32 including a plurality of drying boxes 321 that are arranged along a transfer track; and the transfer platform 33 drives the baskets 4 to move along the transfer track so as to be dried by the corresponding drying boxes 321 in sequence.

In some embodiments, the plurality of drying boxes 321 are arranged in the drying device 32 to accommodate and dry a plurality of baskets 4; the transfer apparatus 31 drives the baskets 4 to move along the transfer track so as to be transferred and dried in sequence, ensuring that each basket 4 can be subjected to the same circles of drying, thereby improving the accuracy of drying of the baskets 4; and moreover, the baskets 4 are sequentially transfer and fed and unloadingd through the transfer apparatus 31, thus avoiding the interference between the baskets during taking and placing.

In some embodiments, a loading and unloading apparatus 34 is further arranged below the drying device 32; as a preferred embodiment of the loading and unloading apparatus 34, the loading and unloading apparatus 34 includes a vertically-arranged tray driving cylinder 341; a tray bearing platform 342 is arranged at a telescopic end of the tray driving cylinder 341, and a tray for accommodating the basket 4 is arranged on the tray bearing platform 342; if the basket 4 is placed on the tray bearing platform 342 for loading, the tray driving cylinder 341 pushes upwards the tray bearing platform 342 to align with an inlet of the drying box 321 on the bottommost layer of the drying device 32, then the tray bearing platform 342 extends into the corresponding drying box 321 through a pushing cylinder (not shown in the figure) to place the basket 4, thus realizing loading; similarly, during unloading, the tray bearing platform 342 extends into the corresponding drying box 321 to take out the basket 4, and then the tray drying cylinder 341 returns back to transfer the basket 4 away from the drying apparatus.

In some embodiments, the loading and unloading apparatus 34 further includes a tray circulation mechanism 343 which is arranged between the two tray bearing platforms 342 and configured to transfer the trays on two tray bearing platforms 342 to each other.

As an optional embodiment, the tray circulation mechanism 343 includes, but is not limited to, a conveyor belt.

In some embodiments, cylinder doors 322 are arranged on both sides of the drying box 321 at a starting point of the transfer track; and cylinder doors 322 are arranged on the sides of the other drying boxes 321 facing the transfer apparatus 31.

As an optional embodiment, the drying box 321 on the bottommost layer of the drying device 32 is the drying box 321 at the starting point of the transfer track, the cylinder doors 322 are arranged on the inner side and outer side of the drying box 321, thus realizing loading from the outer side and transfering from the inner side; the cylinder doors 322 are arranged on the inner sides (the sides facing the transfer apparatus 31) of the other drying boxes 321, such that the transfer apparatus 31 can extend through the cylinder doors 322 to take and place the baskets 4 for realizing transfering.

In some embodiments, two drying devices 32 are provided and are bilaterally symmetrically arranged; the transfer apparatus 31 is arranged between the two drying devices 32, a transfer support of the transfer apparatus 31 is vertically arranged, and a driving member for driving the transfer platform 33 to slide up and down is arranged on the transfer support, so that the transfer platform 33 can be aligned with the drying boxes 321 at different heights on the left and right drying devices 32 in sequence.

As an optional embodiment, the driving member includes, but is not limited to, a lead screw or a hydraulic cylinder.

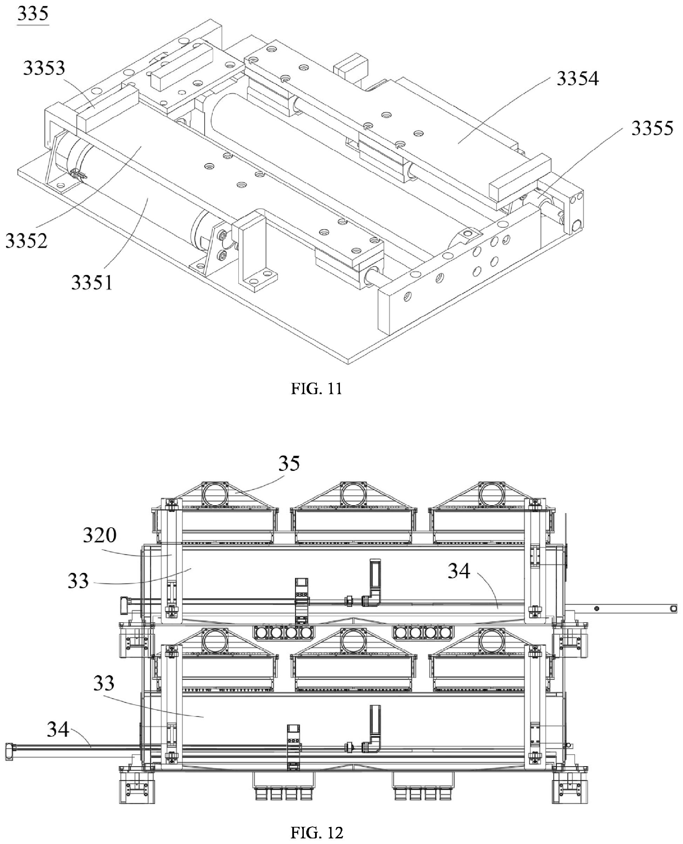

As shown in FIG. 10 and FIG. 11, in some embodiments, the transfer platform 33 includes a bearing plate 331; basket limiting plates 332 are arranged at two ends of the bearing plate 331, and accommodating grooves 333 are formed in the tops of the basket limiting plates 332; and a transposition assembly 335 is arranged between the two basket limiting plates 332. Specifically, a first reversing cylinder 3351 in the transposition assembly 335 drives a first picking plate 3352 to extend into the drying box 321 on the left of the transfer platform 33, a limiting step 3353 on the first picking plate 3352 is clamped into a gap (determined according to the actual shape of the basket 4 or a groove formed in a bottom plate of the basket 4) between the bottom rods of the basket 4, then the first reversing cylinder 3351 returns back, the first picking plate 3352 pulls out the basket 4 from the drying box 321 to the bearing plate 331, at the moment, the bottom rod at the outer end of the basket 4 is clamped into the corresponding accommodating groove 333, and then the transfer cylinder 334 pushes the transposition assembly 335 to move as a whole to clamp the limiting step 3353 on the second picking plate 3354 clamped into the gap between the bottom rods of the basket 4; because the accommodating groove 333 and the limiting step 3353 are arranged in the vertical direction, the limiting step 3353 on the first picking plate 3352 moves out of the gap between the bottom rods of the basket 4, but the basket 4 remains on the bearing plate 331, and then the second reversing cylinder 3355 drives the second picking plate 3354 to push the basket 4 into the drying box 321 on the right of the transfer platform 33, thus realizing transposition of the drying boxes 321 on the left and right of the basket 4.

In some embodiments, if the basket 4 is only vertically transposed in the same drying device 32, only the first reversing cylinder 3351 or the second reversing cylinder 3355 is needed to drive the corresponding reversing plates to extend in and move out.

In some embodiments, the basket lifting apparatus 1 is arranged on the outer side of the drying device 32, and is located above the loading and unloading apparatus 34 and configured to grab and place the basket 4 onto the loading and unloading apparatus 34.

As an optional embodiment, during drying the baskets in series, the baskets 4 are sequentially placed into the drying boxes 321 in turn through the transfer apparatus 31; the baskets 4 are placed into the drying box 321 at the starting point of the transfer track through the loading and unloading apparatus 34; and the basket 4 in the drying box 321 at an end point of the transfer track is taken out through the loading and unloading apparatus 34.

In some embodiments, if there are a large number of the baskets 4 to be dried, the baskets are dried in series, namely, the first basket 4 is placed into the drying box 321 at the starting point of the transfer track (generally the drying box 321 on the bottommost layer of the drying device 32 at the left) for drying; if it is needed to place the second basket 4, the first basket 4 is transfer into the drying box 321 on the last but one layer of the drying device 32 at the left through the transfer apparatus 31, and then the second basket 4 is placed into the drying box 321 on the bottommost layer of the drying device 32 at the left; and the rest can be done in the same manner until the first basket 4 is taken out from the drying box 321 on the bottommost layer of the drying device 32 at the right by the loading and unloading apparatus 34.

As an optional embodiment, in a case of directly drying the baskets 4, the baskets 4 are placed into the corresponding drying boxes 321 through the transfer apparatus 31; the baskets 4 are placed into the corresponding drying boxes 321 at the starting point through the loading and unloading apparatus 34; and the baskets 4 are taken out from the corresponding drying box 321 at the end point through the loading and unloading apparatus 34.

In some embodiments, if few baskets 4 are needed to be dried, a mode of directly drying the baskets 4 can be carried out, that is, two first baskets 4 are correspondingly placed in the drying box 321 on the bottommost layer of the drying device 32 at the left and the drying box 321 on the bottom layer of the drying device 32 at the right, then the two baskets 4 are correspondingly conveyed upwards into the corresponding drying boxes 321 for drying and then returned back into the drying box 321 on the bottommost layer by the transfer apparatus 31, and the baskets 4 at the corresponding positions are taken out through the loading and unloading apparatus 34.

As shown in FIG. 12, as an optional embodiment, the drying apparatus is in a stacked mode and includes: a pair of dryers 35 arranged in a stacked mode; and a transfer platform 36 is arranged in each drying device 1, and the baskets 4 in the two drying devices 1 are conveyed in and conveyed out in the same direction by the transfer platforms 36.

In some embodiments, the pair of dryers 35 are arranged in the stacked mode, the basket 4 in the corresponding dryer 35 is conveyed in and conveyed out in the same direction through the transfer platform 36 in each dryer 35, which avoids interference between the two drying devices 35 during unloading, and realizes the operation of loading to the upper layer while unloading from the lower layer, or unloading from the upper layer while loading to the lower layer, thereby avoiding interference between the upper and lower layers of the drying apparatus during loading and unloading, and improving the use efficiency of the drying apparatus.

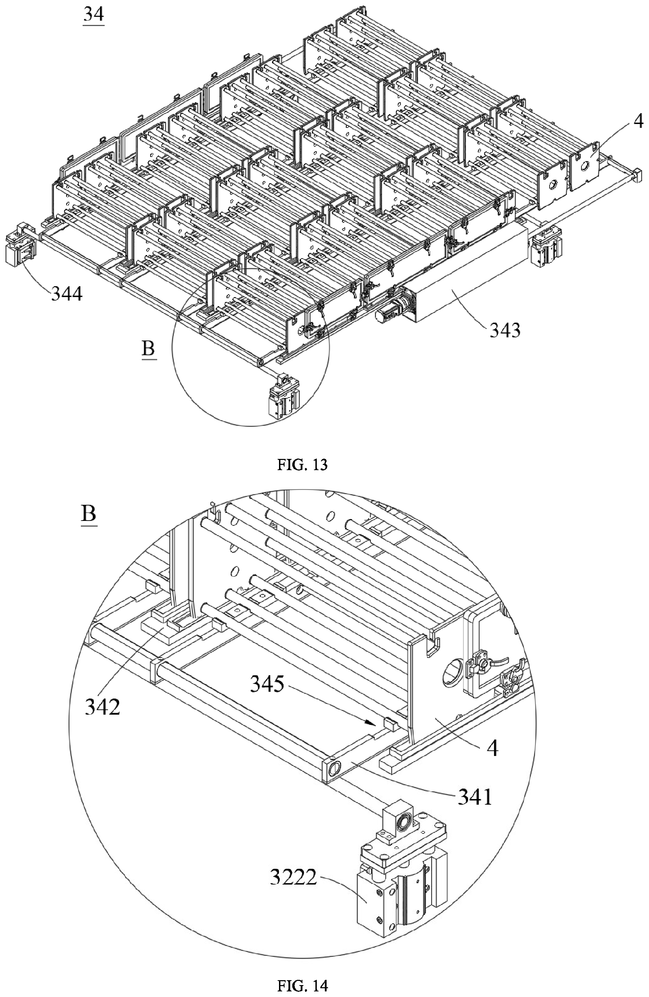

Specifically, as shown in FIG. 13 and FIG. 14, in some embodiments, the transfer platforms 36 include basket holders 361 and basket support frames 362; the basket support frames 362 are fixedly arranged in the drying devices 35 and are configured to bear the baskets 4 in the drying devices 35; and the basket holders 361 are movably arranged at the bottoms of the basket support frames 362; the basket holders 361 can be driven by corresponding driving apparatuses to move out from the drying devices 35 to receive the baskets 4, and then are driven by corresponding driving apparatuses to move back into the drying devices 35 to place the received baskets 4 onto the basket support frames 362 for drying. Positioning grooves 363 formed in the basket holders 361 fit the bottom rods of the baskets 4, such that the baskets 4 can be clamped into the positioning grooves 363 in the basket holders 361, and then the basket holders 361 drive the baskets 4 to move.

Specifically, the driving apparatus include: horizontal cylinders 364 and vertical cylinders 365; fixed ends of the horizontal cylinders 364 are arranged on inner walls of the drying devices 35 while movable ends thereof are connected to the basket holders 361 to push the basket holders 361 to translate left and right; and the fixed ends of the vertical cylinders 365 are also arranged on the inner walls of the drying devices 35 while the movable ends thereof make contact with the basket holders 361 through connecting cross rods; and therefore, the movable ends of the vertical cylinders 365 can extend to drive the connecting cross rods to push upwards the basket holders 361.

In some embodiments, a plurality of drying stations are arranged at equal intervals in the drying devices 35; and a blowing apparatus 37 is arranged on the top of each drying station; and blowing ports of the blowing apparatuses 37 directly face the drying stations.

As a preferred embodiment, there are 6 drying stations, and the blowing apparatus 37 on the top of each drying station remains the blowing state all the time so as to blow and dry the basket 4 on each drying station with hot air; specifically, blowing chambers of the blowing apparatuses 37 have an outline similar to a house, and air inlets 31 (not shown in the figure) are formed in both sides of the blowing chambers, such that air can enter the blowing chambers (not shown in the figure); a plurality of air deflectors (not shown in the figure) are arranged at intervals in the middles of the blowing chambers, with sizes gradually increased from the two ends to centers of the blowing chambers, thereby increasing the air inlet speed; and moreover, a plurality of blowing ports are formed in the bottoms of the blowing chambers and directly face the drying stations, thus blowing air to the baskets 4.

As a preferred embodiment, an air return apparatus is further arranged at the bottom of each drying station, air return chambers (not shown in the figure) of the air return apparatuses have an outline similar to a plate, and air guide ports (not shown in the figure) are formed in the bottoms of the air return chambers, while return air inlets (not shown in the figure) that directly face the drying stations are formed in the tops of the air return chambers, such that the air blown from the blowing port enters the air return chambers through the return air inlets; and air return baffles (not shown in the figure) are arranged in a conical shape in the air return chambers, which make air return faster.

As an optional embodiment, the blowing apparatuses 37 communicate with the air return apparatuses (not shown in the figure) through corresponding pipelines to realize circulation of airflow for drying. Heaters, filters, and other components are further arranged on the corresponding pipelines, thereby further improving the effect of drying the baskets.

In some embodiments, unloading doors 351 are arranged on both sides of the dryer 35 on the upper layer, such that loading from one side while unloading from the other side of the dryer 35 on the upper layer can be realized; the unloading door 351 is arranged on any side of the dryer 35 on the lower layer, and by means of such unloading door 351, loading and unloading can be performed from the same side of the dryer 35; and in addition, a notch allowing the basket holder 361 to move out is formed in the bottom of each unloading door 351, thus the basket holder 361 without the basket 4 can move out without opening the unloading door 351, and the basket holder 361 can move out through the notch in the cylinder door 10; and therefore, the drying effect can be improved, and the temperature in the drying devices 35 can be guaranteed.

As an optional embodiment, if the drying devices 35 are in a loading state, the basket holders 361 are driven by the horizontal cylinders 364 to horizontally slide out; the basket holders 361 that are slid out are pushed upwards to receiving positions by the vertical cylinders 365 to receive the baskets from the basket lifting apparatus; the unloading doors 351 are opened, the basket holders 361 are driven by the horizontal cylinders 21 to horizontally slide into the drying devices 35; the basket holders 361 are driven by the vertical cylinders 365 to move downwards to place the baskets 4 on the basket support frames 362; and if the drying devices 35 are in a unloading state, the basket holders 361 are jacked up by the vertical cylinders 365, then the unloading doors 351 are opened, and the basket holders 361 are driven by the vertical cylinders 365 to horizontally slide to unloading positions.

As a preferred embodiment, during loading to one dryer 35 for the first time, the basket holder 361 moves from the dryer 35 to the receiving position to receive the basket 4 from the basket lifting apparatus 1, and then the basket holder 361 moves back into the dryer 35 to place the received basket 5 at a first drying position (the drying station close to the loading position); during loading to the dryer 35 for the second time, the basket holder 361 horizontally and smoothly moves out firstly and does not make contact with the basket 4 at the first drying position so that the basket holder 361 can independently move out; then the basket holder 361 raises to the receiving position to receive the basket 4, and at the moment, the basket 4 at the first drying station is also lifted along with the raising of the basket holder 361; as the basket holder 361 moves back into the dryer 35 again, the basket holder 361 synchronously moves the basket 4 received that is for the second time and the lifted basket 4 until the basket 4 received for the second time moves above the first drying position. At the moment, the basket 4 placed for the first time moves above a second drying position; as the basket holder 361 moves downwards, the basket 4 received for the second time is placed at the first drying position, and the basket 4 received for the first time is transferred to the second drying position; and the process is repeated until unloading is realized. By means of the above method for loading the basket 4, the basket 4 moves by one station each time, thus ensuring the drying effect after passing through three stations.

In some embodiments, if the dryer 35 on the upper layer is in the loading state, the dryer 35 on the lower layer is in the unloading state or an idle state; and if the dryer 35 on the lower layer is in the loading state, the dryer 35 on the upper layer is in the unloading state or the idle state.

As a preferred embodiment, during loading to the dryer 35 on the upper layer, the basket holder 361 of the dryer 35 on the upper layer moves out, so the basket holder 361 of the dryer 35 on the lower layer does not move out; and during loading to the dryer 35 on the lower layer, the basket holder 361 of the dryer 35 on the lower layer moves out, so the basket holder 361 of the dryer 35 on the upper layer does not move out; even if the drying apparatus always remains the upper-in and lower-out or lower-in and upper-out (staggered) state, the above loading method can avoid interference of the basket holder 361 on the upper layer to the basket holder 361 on the lower layer during loading and unloading.

In conclusion, the basket lifting apparatus 1 in the present invention is configured to lift the baskets 4 from the cleaning tank 2 and transfer the baskets 4 into the drying apparatus for drying, so that the transfer effect is achieved; the basket lifting apparatus 1, the cleaning tank 2, and the drying apparatus are integrally arranged, thus realizing the assembly line operation for silicon wafer cleaning and drying, and improving the production efficiency.

Inspired by the above-described embodiments of the present invention, based on the above description, those skilled in the relevant field can fully make various changes and modifications without departing from the technical concept of the present invention, and such changes and modifications should be encompassed within the scope of the claims of the present invention.

## Claims

1. A basket cleaning and drying system, comprising: a basket lifting apparatus, a cleaning tank, and a drying apparatus, wherein
the basket lifting apparatus is arranged above the cleaning tank to lift the basket in the cleaning tank;
the drying apparatus is arranged beside the basket lifting apparatus; and
the basket lifting apparatus is configured to convey the lifted basket into the drying apparatus for drying.

2. The basket cleaning and drying system according to claim 1, wherein
the basket lifting apparatus comprises: a cross arm on which at least three hanging sets are arranged, each hanging set containing at least two accommodating positions,
each hanging set consisting of a fixed hanging plate and a movable hanging plate, and adjacent hanging sets sharing one hanging plate; and
a mobile column which is vertically arranged on one side of the cross arm to bear and drive the cross arm to move upwards.

3. The basket cleaning and drying system according to claim 2, wherein
the cross arm comprises: a cover plate, a bottom plate, and at least two side plates;
the two side plates are arranged on the bottom plate, and top surface extension lines and bottom surface extension lines of the side plates intersect each other at an end away from the mobile column;
the cover plate in a top view has a trapezoidal outline, with an end away from the mobile column serving as an upper base;
the bottom plate in a top view has a trapezoidal outline, with an end close to the mobile column serving as a lower base;
the two side plates are symmetrically arranged on the bottom plate and are parallel to two side edges of the cover plate; and
each hanging set further comprises at least one connecting rod, and two ends of the connecting rods are correspondingly connected to the fixed hanging plates and the movable hanging plates.

4. The basket cleaning and drying system according to claim 3, wherein
the movable hanging plates comprise hanging plate bodies and inclined pulling cylinders, and fixed ends of the inclined pulling cylinders are arranged on the cross arm;
telescopic ends of the inclined pulling cylinders are connected to the movable hanging plate bodies;
each hanging set comprises at least one detection mechanism, and the detection mechanism comprises a detection rod and a sensor which are arranged on any hanging plate;
hanging gaps allowing the baskets to be hung in are reserved between the bottoms of the detection rods and hooks at the bottoms of the hanging plates;
the detection rods are capable of upwards moving after the baskets are hung into the hanging gaps; and
the sensors are configured to acquire the movement information of the detection rods.

5. The basket cleaning and drying system according to claim 4, wherein
the mobile column is erected on a horizontal moving module, and the horizontal moving module drives the cross beam to horizontally move;
the horizontal moving module comprises: a manipulator slider and a connecting block; and the manipulator slider is connected to the mobile column, and the manipulator slider is erected on the connecting block.

6. The basket cleaning and drying system according to claim 1, wherein
the cleaning tank comprises: a rectangular main cleaning tank with an accommodating chamber, the main cleaning tank being provided with at least two bearing modules in a width direction,
each bearing module comprising at least three rectangular accommodating positions that are sequentially arranged in a length direction of the main cleaning tank, and the length direction of the accommodating positions being parallel to the length direction of the main cleaning tank; and
an auxiliary cleaning tank which is arranged around the main cleaning tank.

7. The basket cleaning and drying system according to claim 6, wherein
an overflow screen is arranged between the main cleaning tank and the auxiliary cleaning tank; a well height of the main cleaning tank is less than that of the auxiliary cleaning tank; and an overflow port is formed in an upper end of the wall of the main cleaning tank to make a medical solution in the tank overflow.

8. The basket cleaning and drying system according to claim 7, wherein
a flow equalizing screen is arranged at the bottom of the main cleaning tank, and a medical solution inlet hole connected to a medical solution pipeline is formed in the bottom of the main cleaning tank;
the flow equalizing screen is located above the medical solution inlet hole to uniformly distribute the medical solution in a tank body.

9. The basket cleaning and drying system according to claim 1, wherein the drying apparatus comprises a pair of drying devices arranged in a stacked mode; and transfer platforms are arranged in the drying devices, and baskets in the two drying devices are correspondingly conveyed in and out in the same direction by the transfer platforms.

10. The basket cleaning and drying system according to claim 9, wherein the transfer platforms comprise basket holders and basket support frames; basket bearing positions are arranged on the basket support frames; and positioning grooves are formed in sidewalls of the basket holders and fit bottom rods of the baskets by shape.

11. The basket cleaning and drying system according to claim 10, wherein the transfer platforms further comprise: horizontal cylinders and vertical cylinders; the horizontal cylinders are connected to the basket holders to drive the basket holders to translate left and right; and telescopic ends of the vertical cylinders abut against the basket holders to push the basket holders to move up and down.

12. The basket cleaning and drying system according to claim 1, wherein the drying apparatus comprises:
a transfer apparatus comprising a transfer platform; and
a drying device comprising a plurality of drying boxes that are arranged along a transfer track; and
the transfer platform drives the basket to move along a transfer track to be dried through the corresponding drying boxes in sequence.

13. The basket cleaning and drying system according to claim 12, wherein the transfer apparatus comprises a transfer support, and a driving member for driving the transfer platform to slide up and down is arranged on the transfer support.

14. The basket cleaning and drying system according to claim 13, wherein the transfer platform comprises bearing plate; basket limiting plates are arranged at two ends of the bearing plate, and accommodating grooves for accommodating bottom rods of the baskets are formed in the tops of the basket limiting plates; and a transfer cylinder is arranged on the bearing plate; and
a fixed end of the transfer cylinder is arranged on the bearing plate while a telescopic end of the transfer cylinder is connected to a transposition assembly which is configured to transfer and transpose the baskets in the drying boxes.

15. The basket cleaning and drying system according to claim 14, wherein the transposition assembly consists of a first reversing cylinder and a second reversing cylinder;
a first picking plate is arranged on the telescopic end of the first reversing cylinder, and the first reversing cylinder is configured to push the first picking plate to extend into the drying box at the left of the transfer platform to pull out the basket;
a second picking plate is arranged on the telescopic end of the second reversing cylinder, and the first reversing cylinder is configured to push the second picking plate to extend into the drying box at the right of the transfer platform to convey the basket that is picked by the first picking plate into the corresponding drying box; and
limiting steps are arranged on both the first picking plate and the second picking plate, with the sizes adapted to a gap between two bottom rods of the basket.
